# EUROPEAN PATENT APPLICATION

(11) **EP 2 063 536 A1**
(43) Date of publication of application: **27.05.2009**
(21) Application number: 07121514.9
(22) Date of filing: 26.11.2007
(51) Int. Cl.: H03M 3/02, H04B 14/06

(54) **A switching signal generator**

(71) Applicant: Alcatel-Lucent Deutschland AG, 70435 Stuttgart (DE); LUCENT TECHNOLOGIES INC., Murray Hill NJ 07974-0636 (US)
(72) Inventor: Fischer, Georg, 90425 Nürnberg (DE)
(74) Representative: Richardt, Markus Albert

(57) **Abstract**

The invention relates to a switching signal generator (101) for generating a switching signal having discrete values from a bandpass signal, the bandpass signal having a first center frequency. The switching signal generator (101) comprises a noise shaping means (123) for shaping a frequency characteristic of a quantization noise, the noise shaping means (123) being configured to generate a first frequency notch (305) at the first center frequency and a second frequency notch (307) at a second center frequency to reduce a power density of the quantization noise at the first center frequency and at the second center frequency.

## Description

Switch mode amplifiers, e.g. Class-S radio frequency power amplifiers, are driven by a switching signal resulting from converting a radio frequency analog signal forming e.g. an information signal into a switching signal having discrete values using e.g. a sigma-delta modulator. Since the amplifier is arranged downstream the switching signal generator, a quantizing noise associated with converting the analog signal into the discrete value switching signal may excite the amplifier also at unwanted frequencies which may result in energy losses. Furthermore, the efficiency of a Class-S radio frequency power amplifier is degraded by an imperfection of transistors forming e.g. an amplification stage which results in e.g. low frequency transistor dispersion. Dispersion originates from loss mechanisms occurring inside the power amplifier and resulting in a significant degradation of a maximum achievable efficiency.

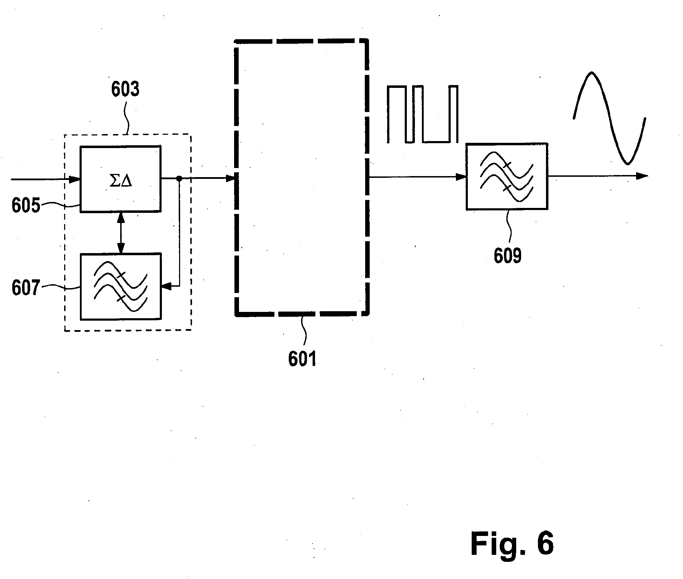

Fig. 6 shows a basic architecture of a switch mode power amplifier with a voltage switched circuit topology. The power amplifier comprises an amplification stage 601 being driven by a switching signal generator 603 comprising a sigma-delta modulator 605 and a noise shaping filter 607 arranged in a feedback loop. The switching signal generator 603 drives the amplification stage 601 by a one-bit switching signal resulting e.g. from converting an analog signal by the sigma-delta modulator 605. The amplification stage 601 amplifies the switching signal and provides the same to a reconstruction filter 609 converting the amplified switching signal into an analog signal representing an amplified version of the analog input signal.

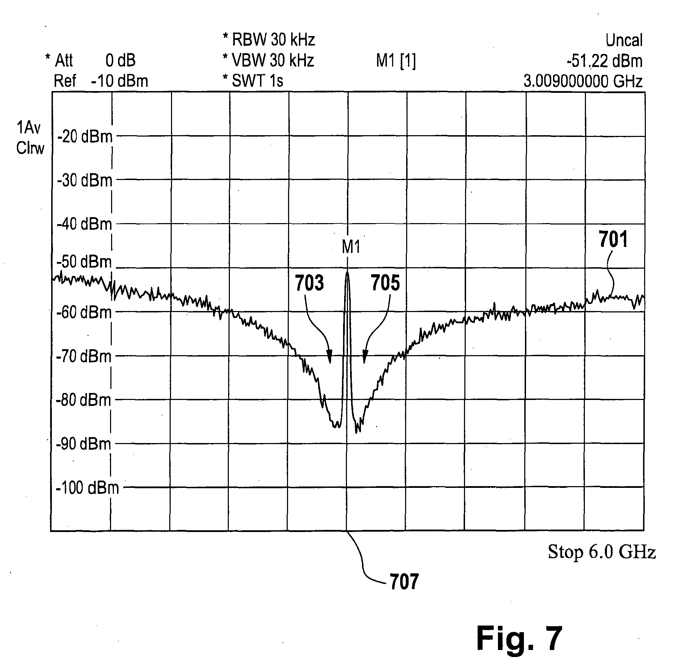

In order to reduce the impact of the quantizing noise, the filter 607 is provided to shape the quantizing noise such that a frequency notch in noise power density spectrum the frequency of a wanted signal is generated. Fig. 7 shows a noise power density spectrum 701 together with a wanted signal, a sub-notch 703 and a further sub-notch 705 in proximity of a wanted frequency 707. The sub-notches 703 and 705 form a composed notch with a center frequency determined by the wanted frequency 707. Thus, the noise power density around the wanted signal is significantly lower than the noise power density in other frequency regions which may degrade the performance of e.g. an amplifier receiving a switching signal.

It is the object of the invention to provide an improved noise shaping concept for switching signal generators.

This object is achieved by the features of the independent claims.

The invention is based on the finding that the noise shaping approach can be improved when generating a further notch in a frequency characteristic of the quantizing noise associated with the analog to digital conversion around a center frequency at which further unwanted effects in further stages arranged downstream the switching signal generator may occur.

For example, frequency dispersion in transistors typically occurs around low frequencies around 20 to 100 MHz which is a source for additional power dissipation when additionally exciting the transistors at those frequencies. According to the invention, the switching signal generator, e.g. a delta-sigma-modulator, is designed such as to provide a secondary noise notch around the further center frequency to reduce the noise power within the corresponding spectral band. More specifically, the quantizing noise is shaped such that at least two notches in the frequency spectrum of the quantizing noise are provided. The first notch is preferably arranged around the first center frequency coinciding with the frequency of a signal to be e.g. amplified or processed. The second notch is arranged around the second center frequency spaced apart from the first center frequency. In particular, the second frequency notch is provided so as to reduce the noise power density in a further frequency region e.g. between 20 to 100 MHz in order to reduce the effects associated with e.g. dispersion in the electronic elements arranged downstream the switching signal generator like power amplifiers or digitally controlled oscillators.

The first and the second frequency notch in the frequency characteristic of the quantizing noise may be generated upon a basis of a filter design rule according to which a noise shaping filter as e.g. employed in the delta sigma modulators is designed such as to additionally comprise at least one pole and/or at least one zero on a right hand side of a complex pole-zero-domain. Preferably, the filter coefficients are designed such that a higher filter degree with e.g. 8 poles and/or 8 zeros results. The noise shaping filter may be a finite impulse response (FIR) filter or an infinite impulse response (IIR) filter.

The invention relates according to an aspect to a switching signal generator for generating a switching signal having discrete values from a bandpass signal, the bandpass signal having a first center frequency, the switching signal generator comprising a conversion element for converting e.g. an analog bandpass signal into a switching signal having discrete values, the analog bandpass signal having a first center frequency. The switching signal generator comprises a noise shaping means for shaping a frequency characteristic of a quantization noise, the noise shaping means being configured to generate a first frequency notch at the predetermined first center frequency and a second frequency notch at a second center frequency to reduce a power density of the quantization noise at the first center frequency and at the second center frequency.

The signal generator may be or may comprise e.g. an analog to digital converter or a bandpass delta sigma modulator with an analog input (CT-BPDSM: Continuous Time Bandpass Delta Sigma Modulator) or with a digital input (DT-BPDSM: Discrete Time Bandpass Delta Sigma Modulator) or a Highpass Delta Sigma Modulator (HPDSM) with an analog or digital input (CT-HPDSM, DT-HPDSM).

According to an embodiment, the second center frequency is variably adjustable.

According to an embodiment, the noise shaping means comprises digital filter coefficients being determined by at least one pole or at least one zero on a right-hand side of a complex pole-zero-plane. By way of example, the zeros and/or the poles may be arranged at 1+j0 or in vicinity thereof. In other words, the zeros and the poles may be arranged such that a respective imaginary component is less than a respective real component, e.g. less than 50% of the real component.

According to an embodiment, the switching signal generator further comprises a converting element, in particular a sigma-delta-modulator, being configured to convert an analog bandpass signal into a switching signal.

According to an embodiment, the switching signal generator may be a sigma-delta-modulator which may also have a digital or an analog input.

The invention relates according to another aspect to a switching signal generating system comprising the inventive switching signal generator and a processing element arranged downstream the switching signal generator, the processing eiement processing the switching signal at the first center frequency, wherein the second center frequency is determined by an excitation frequency of the processing element and wherein the noise shaping means is configured to generate the second frequency notch so as to reduce the excitation of the processing element at the excitation frequency.

According to an embodiment, the second notch is determined by a dissipation frequency or by a dispersion frequency of the processing element.

According to an embodiment, the processing element is a switch mode amplifier or a digitally controlled oscillator.

The invention relates according to another aspect to a method for generating a switching signal having discrete values from a bandpass signal, the bandpass signal having a first center frequency. The method comprises shaping a frequency characteristic of a quantization noise by generating a first frequency notch at the predetermined center frequency and by generating a second frequency notch at a second center frequency to reduce a power density of the quantization noise at the first center frequency and at the second center frequency.

According to an embodiment, the method comprises generating a switching signal from a bandpass signal according to the invention and processing the switching signal at the first center frequency by a processing element, wherein the second center frequency is determined by an excitation frequency of the processing element and the second frequency notch is generated so as to reduce the excitation of the processing element at the excitation frequency.

The invention relates according to an aspect to a switching signal generating method. The method comprises generating a switching signal from a bandpass signal according to the invention and processing the switching signal at the first center frequency by a processing element, wherein the second center frequency is determined by an excitation frequency of the processing element and the second frequency notch is generated so as to reduce the excitation of the processing element at the excitation frequency.

Further embodiments of the invention will be described with respect to the following figures, in which:
- Fig. 1: shows a switching signal generating system with a switch mode amplifier;
- Fig. 2: shows a low frequency dispersion of a GaN transistor;
- Fig. 3: shows a noise power density spectrum;
- Fig. 4: shows an arrangement of poles and zeros in a complex pole-zero-plane;
- Fig. 5: shows a noise power density spectrum;
- Fig. 6: shows a switched mode amplifier system; and
- Fig. 7: shows a noise power density spectrum.

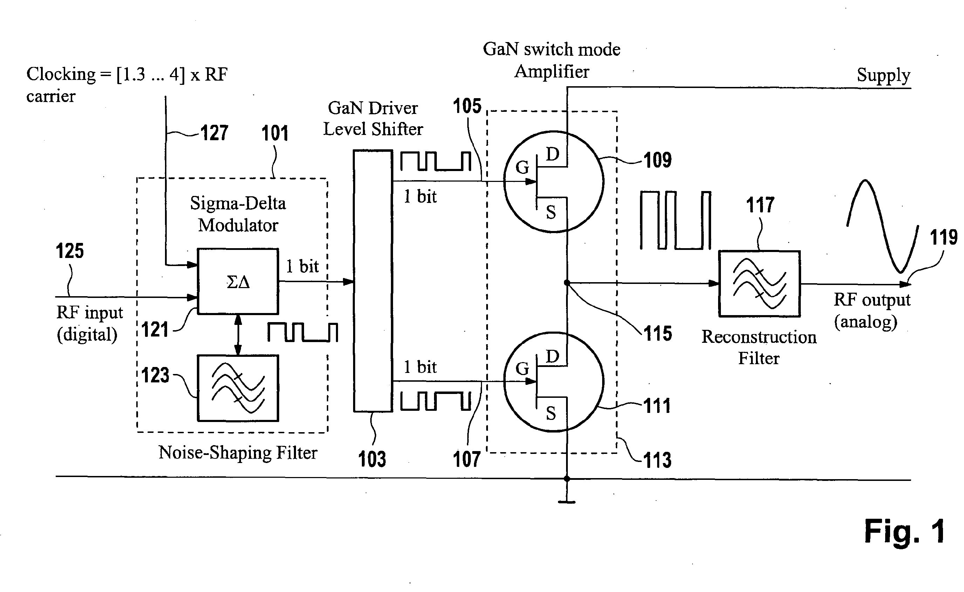

The system shown in Fig. 1 comprises a switching signal generator 101 having an output connected to an input of a level shifter 103, e.g. a GaN level shifter. The level shifter 103 has a first output 105 and a second output 107 e.g. in antiphase which are respectively connected to a gate of a first transistor 109 and a gate of a second transistor 111 of a switch mode amplifier 113, for example of a gallium nitride (GaN) switch mode amplifier. A drain of the first transistor 109 is connected to a power supply wherein a source of the first transistor 109 is connected to a drain of the second transistor 111 at a node 115 forming an output of the switch mode amplifier 113. The system further comprises a reconstruction filter 117 having an input connected to the node 115. An output 119 of the reconstruction filter 117 forms an output of the system.

The switching signal generator 101 may comprise a conversion element 121, e.g. a sigma-delta modulator, and a noise shaping filter 123 connected to the conversion element 121. The noise shaping filter 123 may be e.g. arranged in a feedback loop of the switching signal generator 101 or may be coupled to the same for filtering the quantizing noise. However, the switching signal generator 101 may be a sigma-delta modulator comprising a noise shaping filter.

The conversion element 121 has an input 125 for receiving a radio frequency (RF) input signal which may be a digital or an analogue input signal and a clock input 127 for receiving a clocking carrier which may equal to the radio frequency carrier of the RF input signal or to a multiple (2, 3 or 4) thereof as depicted in Fig. 1 or e.g.4/3 of the radio frequency carrier of the RF input signal.

The switching signal generator 101 converts the RF input signal into a one-bit switching signal having discrete amplitude values 0 or 1. Simultaneously, the noise shaping filter 123 shapes the frequency characteristic of the quantizing noise in order to generate at least two notches, one notch around the center frequency determined by the frequency of the RF input signal, the other notch around e.g. a further center frequency determined by the low frequency dispersion of the transistors 109 and 111.

The one-bit switching signal is provided to the GaN driver and to the level shifter 103 which generates two preferably identical or two antiphase one-bit switching signals upon the basis of the switching signal provided by the switching signal generator 101. The switching signals are respectively provided to the gates of the transistors 109 and 111 of the GaN switch mode amplifier which generates upon a basis thereof an amplified switching signal provided to the reconstruction filter 117 generating the RF analog output signal.

It shall be noted that the switching signal generator 101 may also drive a digitally controlled oscillator or a synthesizer or any electronic component which is driven by a switching signal. Moreover, the topology shown in Fig. 1 is correspondingly applicable to other circuit topologies of Class-S like current switched or simplified current switched elements like e.g. amplifiers. Moreover, the principles of the voltage switched topology shown in Fig. 1 are correspondingly applicable to current switched topologies.

According to an aspect, the digital output of the switching signal generator 101 may have a resolution which is greater than 1 bit. In this case, the switch mode amplifier 113 processes a plurality of digital amplitude values.

The topology shown in Fig. 1 may be employed for voltage switched approaches and for current switched approaches, since in either case correct correct antiphase signals may be provided by the level shifter 103.

A Class-S power amplifier architecture as shown in Fig. 1 may form a digital amplifier preferably comprising the switching signal generator 121 for providing a one-bit digital bit stream. The driver 103 provides anti-phase switching signals, wherein the final switching amplifier 113 and the reconstruction filter 117 are provided for generating an amplified digital signal and for converting the amplified digital signal to an analog signal.

In order to properly dimension the noise shape in a frequency domain, higher order delta-sigma modulators may preferably be employed due to a high degree of freedom allowing dimensioning filter coefficients such that a secondary noise notch according to the invention is provided. The requirement for the secondary noise notch may be incorporated into the requirements for the filter design. Thus, the inventive concept is also applicable to standard sigma-delta modulators by replacing standard filter coefficients by filter coefficients having e.g. at least 1 zero and/or 1 pole in the right-hand half of the complex domain. The two or more notches in the frequency characteristic of the quantizing noise contribute to an increase of the efficiency of a system shown e.g. in Fig. 1 by 10 to 15% for UMTS (Universal Mobile Telecommunication System) or LTE (Long Term Evolution). Furthermore, the reduced energy consumption contributes to an OPEX reduction (Operational Expenditures) for network operators. Furthermore, e.g. switch mode power amplifiers driven by the inventive switching signal generator require less cooling effort which allows using a more dense packaging technology for packaging the power amplifiers which further results in a reduced CAPEX (Capital Expenditures).

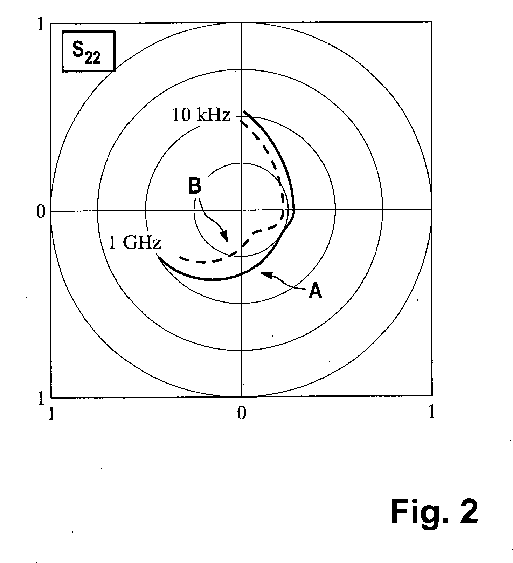

Fig. 2 shows the low frequency dispersion of a GaN transistor in the range between 10 kHz and 1 GHz. The traces A and B show S₂₂ parameter for different amplifiers.

The frequency dispersion in a transistor typically occurs at low frequency in a frequency band between 20 to 100 MHz which is the reason for the term "low frequency dispersion". The aforementioned frequencies are low compared with RF frequencies around 1 or 2 GHz. In this regard, GaN transistors may preferably be used with a class-S amplifier as they offer high voltages, high currents and high frequencies simultaneously. In particular, the kink in the parameter S₂₂ of the output stray parameter in Fig. 2 is clearly visible. The S₂₂ trace becomes more inbound from the periphery which results in increased losses. Preferably, the trace should have an equal distance from the center point with a frequency sweep. Thus, an increased noise power density spectrum within the frequency dispersion range as depicted in Fig. 7 would excite the transistors to generate losses due to the low frequency dispersion.

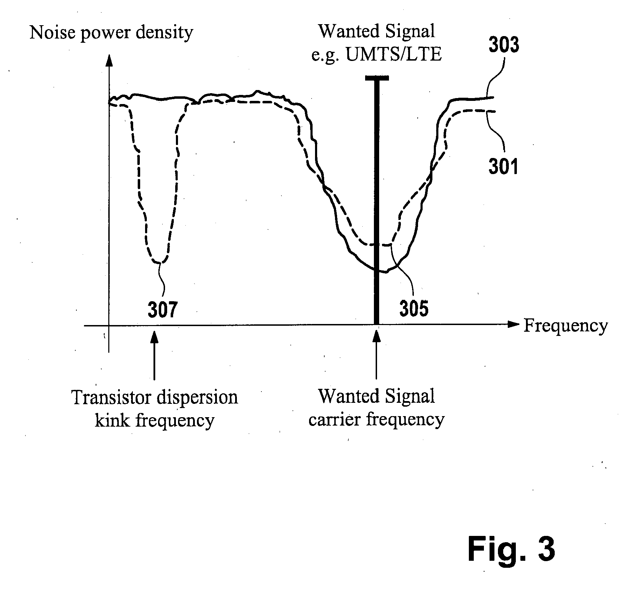

Fig. 3 shows the noise power density 301 according to the invention (dashed line 301) versus the conventional noise power density (solid line 303). The inventive noise power density 301 comprises a first frequency notch 305 having a center frequency corresponding to e.g. a wanted carrier frequency of e.g. a UMTS or LTE signal. Correspondingly, the traditional noise power density comprises a frequency notch around the same frequency. The inventive noise power density additionally comprises a second frequency notch 307 having a center frequency being determined by e.g. a transistor dispersion kink frequency.

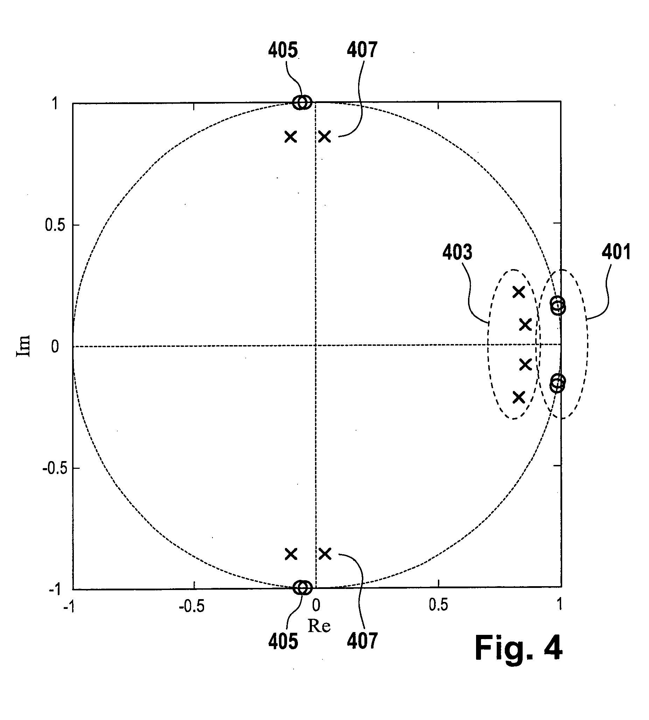

The inventive noise power density 301 may be obtained by shaping the quantizing noise in e.g. a delta-sigma modulator forming the switching signal generator using filter coefficients having a distribution of zeros and poles in a complex zero-pole-domain as depicted in Fig. 4. In order to obtain the second frequency notch, four zeros 401 and four poles 403 arranged on a right hand side of the imaginary axis are arranged.

The filter coefficients are further determined by four zeros 405 arranged on the left hand side of the imaginary axis and by further four poles 407. However, the zeros may be arranged on the right hand side or on the left hand side of the imaginary axis if they are arranged near the imaginary axis.

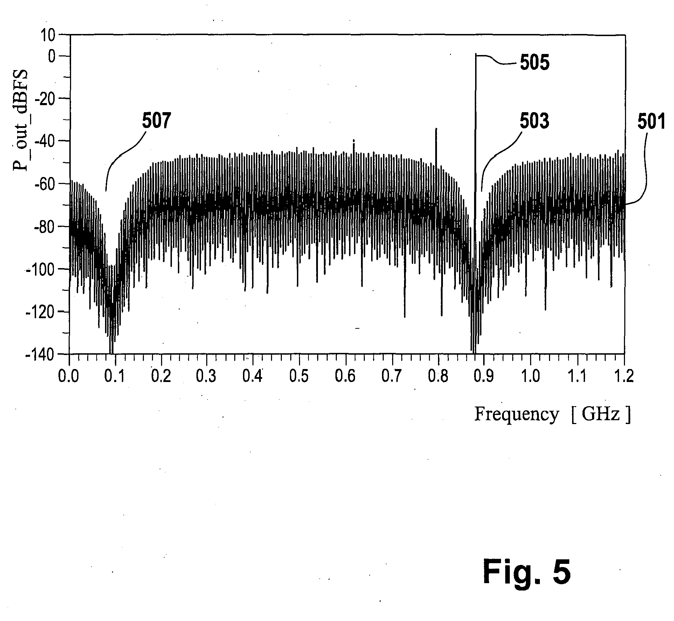

Fig. 5 shows the corresponding noise power density 501 with a first frequency notch 503 around a wanted frequency 505 and a second frequency notch 507.

In order to achieve the inventive improvement, no additional hardware is required. In particular, different filter coefficients may be employed determining the filter characteristic of a filter arranged inside a delta-sigma modulator. As the delta-sigma modulator is typically implemented in DSPs (Digital Signal Processor) or FPGAs (Field Programmable Gate Array), the inventive approach may also be implemented by loading new filter coefficients into the noise shaping filter of the delta-sigma modulator.

## Claims

1. A switching signal generator (101) for generating a switching signal having discrete values from a bandpass signal, the bandpass signal having a first center frequency, the switching signal generator (101) comprising:
- a noise shaping means (123) for shaping a frequency characteristic of a quantization noise, the noise shaping means (123) being configured to generate a first frequency notch (305) at the first center frequency and a second frequency notch (307) at a second center frequency to reduce a power density of the quantization noise at the first center frequency and at the second center frequency.

2. The switching signal generator according to claim 1, the second center frequency being variably adjustable.

3. The switching signal generator according to claim 1 or 2, the noise shaping means (123) comprising digital filter coefficients being determined by at least one pole or at least one zero on a right-hand side or and/or on a left-hand side of a complex pole-zero-plane.

4. The switching signal generator according to anyone of the claims 1 to 3, further comprising a converting element (121), in particular a sigma-delta-modulator, being configured to convert the bandpass signal into a switching signal.

5. The switching signal generator according to anyone of the claims 1 to 4, the switching signal generator being a sigma-delta-modulator.

6. A switching signal generating system, comprising:
- the switching signal generator (101) according to anyone to the claims 1 o 5; and
- a processing element (113) arranged downstream the switching signal generator, the processing element (113) processing the switching signal at the first center frequency; wherein
- the second center frequency is determined by an excitation frequency of the processing element (113); and wherein
- the noise shaping means is configured to generate the second frequency notch (307) so as to reduce the excitation of the processing element (113) at the excitation frequency.

7. The switching signal generating system according to claim 6, the second frequency notch (307) being determined by a dissipation frequency or by a dispersion frequency of the processing element (113).

8. The switching signal generating system according to claim 6 or 7, the processing element (113) being a switch mode amplifier or a digitally controlled oscillator.

9. A method for generating a switching signal having discrete values from a bandpass signal, the bandpass signal having a first center frequency, the method comprising:
- shaping a frequency characteristic of a quantization noise by generating a first frequency notch at the first center frequency and by generating a second frequency notch at a second center frequency to reduce a power density spectrum of the quantization noise at the first center frequency and at the second center frequency.

10. A switching signal generating method, comprising:
- generating a switching signal from a bandpass signal according to claim 9; and
- processing the switching signal at the first center frequency by a processing element; wherein
- the second center frequency is determined by an excitation frequency of the processing element and the second frequency notch is generated so as to reduce the excitation of the processing element at the excitation frequency.
